(19) Europäisches Patentamt
European Patent Office
Office européen des brevets

(11) Veröffentlichungsnummer: **0 468 386 A1**

(12) # EUROPÄISCHE PATENTANMELDUNG

(21) Anmeldenummer: **91112175.4**

(22) Anmeldetag: **20.07.91**

(51) Int. Cl.$^5$: **C23C 16/06**, C07F 19/00, C01G 1/00

(30) Priorität: **27.07.90 DE 4023883**

(43) Veröffentlichungstag der Anmeldung: **29.01.92 Patentblatt 92/05**

(84) Benannte Vertragsstaaten: **AT BE CH DE DK ES FR GB IT LI NL SE**

(71) Anmelder: **Kali-Chemie Aktiengesellschaft**
**Postfach 220, Hans-Böckler-Allee 20**
**W-3000 Hannover 1(DE)**

(72) Erfinder: **Kruck, Thomas**
**Am Wachberg 9**
**W-5024 Erftstadt-Bliesheim(DE)**
Erfinder: **Behrendorf, Norbert**
**An der Pulvermühle 18**
**W-5000 Köln 91(DE)**

(74) Vertreter: **Lauer, Dieter, Dr.**
**c/o Solvay Deutschland GmbH, Postfach 220**
**W-3000 Hannover(DE)**

(54) **Verfahren zur Abscheidung von Ubergangsmetall enthaltenden Schichten.**

(57) Beschrieben wird die Herstellung Übergangsmetall, insbesondere Wolfram, enthaltender Schichten, bevorzugt nach dem CVD-Verfahren. Neue Koordinationsverbindungen werden ebenfalls beschrieben.

EP 0 468 386 A1

Die Erfindung bezieht sich auf ein Verfahren zur Abscheidung einer Übergangsmetall enthaltenden Schicht auf einem Substrat durch Zersetzung von Halogenphosphan enthaltenden Koordinationsverbindungen von Übergangsmetallen mit der Wertigkeit 0 sowie neue, im erfindungsgemäßen Verfahren verwendbare Verbindungen.

Es ist bekannt, Substrate durch Oberflächenbeschichtung so zu modifizieren, daß ihre Oberfläche bestimmte funktionale Eigenschaften aufweist. Beispielsweise kann man den elektrischen Strom leitende oder halbleitende Schichten, z.B. Leiterbahnen aufbringen. Aus der europäischen Patentanmeldung EP-A 338 206 ist beispielsweise ein Verfahren zum konformen Abscheiden von Wolfram auf Halbleitersubstrate bei der Herstellung von höchstintegrierten Schaltungen bekannt. Als Ausgangsverbindungen werden in jener Anmeldung Wolframverbindungen verwendet. Es handelt sich um $W(PF_3)_6$,$W(PCl_3)_6$ oder Komplexe des Typs $W(PF_3)_5L$, worin L Stickstoff, Aceton, andere Ketone oder Aldehyde, Kohlenmonoxid, Tolan, Acetonitril, Ether oder Tetrahydrofuran bedeutet. Andere einsetzbare Wolframverbindungen betreffen Komplexe mit Tetrahapto- oder Hexahaptoliganden.

Durch Zersetzung dieser Wolfram-Verbindungen, insbesondere nach dem thermischen Verfahren, Laser- oder Plasma-CVD-Verfahren bei vermindertem Druck und erhöhter Temperatur, können in Isolationsschichten gesetzte Kontaktlöcher mit Wolfram aufgefüllt werden. Dieses Verfahren dient zur Ausbildung von elektrischen Leiterbahnen bei der Herstellung von höchstintegrierten Halbleiterschaltungen.

Aufgabe der vorliegenden Erfindung ist es, ein Verfahren anzugeben, mit welchem sich in vorteilhafter Weise außer Wolfram auch andere Übergangsmetalle enthaltende Schichten abscheiden lassen. Weiterhin ist es Aufgabe der vorliegenden Erfindung, die Palette verfügbarer Verbindungen, mit welchen sich Übergangsmetall enthaltende Schichten abscheiden lassen, vorteilhaft zu erweitern. Diese Aufgaben werden durch das erfindungsgemäße Verfahren und die neuen, im erfindungsgemäßen Verfahren einsetzbaren Verbindungen gelöst.

Das erfindungemäße Verfahren zur Abscheidung von Übergangsmetall enthaltenden Schichten durch Zersetzung von Halogenphosphane enthaltenden Koordinationsverbindungen von Übergangsmetallen mit der Wertigkeit 0 ist dadurch gekennzeichnet, daß man eine Verbindung der allgemeinen Formel (I) einsetzt

$MtL_{n-1}(PCl_3)$ (I)

worin

L CO (Kohlenmonoxid) oder $PF_3$ - (Phosphortrifluorid) bedeutet,

Mt ein Übergangsmetall, ausgewählt aus der Nikkel, Palladium, Platin, Vanadium, Ruthenium, Osmium, Eisen, Chrom, Molybdän und Wolfram umfassenden Gruppe bedeutet und

n die Koordinationszahl des betreffenden Metallatoms ist und für Nickel, Palladium oder Platin n gleich 4 bedeutet, für Ruthenium, Osmium oder Eisen n gleich 5 bedeutet, und für Vanadium, Chrom, Molybdän oder Wolfram n gleich 6 bedeutet.

Sofern Mt Palladium oder Platin bedeutet, ist L bevorzugt $PF_3$.

Im Rahmen der vorliegenden Erfindung bedeutet der Begriff "Übergangsmetall" enthaltende Schichten, daß die Übergangsmetalle in den Schichten sowohl in metallischer Form als auch in Form von Übergangsmetallverbindungen enthalten sein können.

Bevorzugt bedeutet Mt Chrom, Molybdän, Wolfram, Nickel oder Palladium.

Ganz besonders bevorzugt bedeutet Mt Wolfram.

Der Ligand L bedeutet bevorzugt $PF_3$ - (Trifluorphosphan, Phosphortrifluorid).

In den Verbindungen der Formel (I) sind somit pro Metallatom (n-1) Liganden L vorhanden. Die Formel (I) umfaßt sowohl Verbindungen, in denen alle Liganden L gleich sind sowie Verbindungen, in denen verschiedene Liganden L vorhanden sind.

Verwendbar sind somit Verbindungen der Formeln $Mt(PF_3)_{n-1}(PCl_3)$ (Ia), beispielsweise $W(PF_3)_5(PCl_3)$, $Mo(PF_3)_5(PCl_3)$, $Cr(PF_3)_5(PCl_3)$, $Ni(PF_3)_3(PCl_3)$ oder $Pd(PF_3)_3(PCl_3)$, sowie der Formel $Mt(CO)_{n-1}(PCl_3)$ (Ib), beispielsweise $W(CO)_5(PCl_3)$, $Cr(CO)_5(PCl_3)$, $Mo(CO)_5(PCl_3)$ oder $Ni(CO)_3(PCl_3)$.

Von der Formel (I) umfaßt und im erfindungsgemäßen Verfahren einsetzbar sind weiterhin unterschiedliche Liganden L aufweisende Verbindungen der Formel $Mt(PF_3)_{n-1-m}(CO)_m(PCl_3)$(Ic), beispielsweise $W(PF_3)_3(CO)_2(PCl_3)$. Hierbei besitzen n und Mt die vorgenannte Bedeutung, m ist ganzzahlig und bedeutet 1 bis (n-2). Für n = 5 beispielsweise bedeutet m 0, 1, 2 oder 3.

Bevorzugt verwendet man Verbindungen, in denen alle Liganden L gleich sind, also Verbindungen der Formel (Ia) oder (Ib). Eine zur Abscheidung von Wolfram enthaltenden Schichten besonders gut geeignete Verbindung ist $W(PF_3)_5(PCl_3)$.

Die vorliegende Erfindung wird nun anhand der bevorzugten Ausführungsform, daß nämlich Mt Wolfram bedeutet, weiter erläutert.

Zur Abscheidung einer Wolfram enthaltenden Schicht kann der Fachmann die Abscheidung aus der kondensierten Phase oder aus der Gas- bzw. Dampfphase vornehmen. Für den Fachmann ist dabei selbstverständlich, daß er nicht nur eine bestimmte Verbindung der allgemeinen Formel (I),

sondern auch Gemische solcher Verbindungen einsetzen kann.

Zur Abscheidung aus der kondensierten Phase bringt der Fachmann die Verbindung der Formel (I) ohne Lösungsmittel oder vorzugsweise in einem Lösungsmittel gelöst auf dem Substrat auf und zersetzt die Verbindung. Als Lösungsmittel können polare oder unpolare, aprotische organische Lösungsmittel, die gewünschtenfalls koordinierende Eigenschaften aufweisen können, verwendet werden. Geeignet sind beispielsweise aliphatische Kohlenwasserstoffe wie Pentan oder Petrolbenzin, aromatische Kohlenwasserstoffe wie Benzol oder Toluol oder Ether wie Tetrahydrofuran.

Um die jeweilige Ausgangsverbindung auf dem Substrat aufzubringen, kann man sich bekannter Methoden bedienen, beispielsweise kann man das Substrat in die Verbindung oder eine entsprechende Lösung eintauchen, man kann die Ausgangsverbindung oder eine entsprechende Lösung auf dem Substrat aufstreichen oder, bevorzugt, die Verbindung oder eine entsprechende Lösung auf das Substrat aufsprühen.

Mittels dieser Ausführungsform des erfindungsgemäßen Verfahrens, nämlich dem Aufbringen der Ausgangsverbindung (bzw. einem entsprechenden Gemisch von Ausgangsverbindungen) aus der kondensierten Phase, gelingt es, auch große Flächen sehr schnell zu beschichten.

Dann erfolgt die Zersetzung der aus der kondensierten Phase auf dem Substrat aufgebrachten Ausgangsverbindung zur Abscheidung einer Wolfram enthaltenden Schicht, gewünschtenfalls unter vermindertem Druck. Zweckmäßig bewirkt man die Zersetzung thermisch oder durch Photolyse, z.B. durch einen bei der entsprechenden Wellenlänge betriebenen Laser oder eine UV-Lampe.

Die Zersetzung kann man plasmainduziert durchführen. Hierzu eignen sich die verschiedenen bekannten Verfahren.

Beispielsweise kann man ein thermisches Plasmaverfahren, z.B. Lichtbogenplasma oder Plasmajet, anwenden. Der Druck liegt dann üblicherweise zwischen 10 Torr und Normaldruck.

Gut geeignet sind insbesondere auch Niederdruckplasmaverfahren, z.B. Gleichstromplasmaverfahren, Glimmentladungsplasmaverfahren und Wechselstromplasmaverfahren, z.B. Niederfrequenz-, Mittelfrequenz-, Hochfrequenzplasmaverfahren und Mikrowellenplasmaverfahren. Man arbeitet üblicherweise bei Drucken unterhalb 10 mbar, beispielsweise zwischen $10^{-2}$ und 1 mbar.

Die plasmainduzierte Zersetzung erfolgt in bekannten Plasmareaktoren. Verwendbar sind beispielsweise Rohr-, Tunnel-, Parallelplatten-und Coronaentladungsreaktoren. Da die Zersetzung im Plasma gewünschtenfalls bei niedrigen Temperaturen durchgeführt werden kann, ist die Zersetzung im Plasma gut geeignet zur Beschichtung von Substraten mit ver hältnismäßig geringerer Thermostabilität, beispielsweise für Beschichtung von Kunststoffen.

Der Fachmann kann durch Zusatz eines Reaktivgases die Form, in welcher das Wolfram in der Schicht vorliegt, beeinflussen. Dies, sowie die Möglichkeit der gleichzeitigen Abscheidung anderer Metalle oder der sukzessiven Abscheidung weiterer, insbesondere weiterer Schichten mit anderer Zusammensetzung, wird noch erläutert.

Eine andere Ausführungsform des erfindungsgemäßen Verfahrens betrifft die Zersetzung der Ausgangsverbindung in der Gas- bzw. Dampfphase. In der Dampfphase sind neben der gasförmigen vorliegenden Ausgangsverbindung auch noch Anteile der kondensiert vorliegenden Ausgangsverbindung in feinster Verteilung enthalten. Die Abscheidung aus der Gas- bzw. Dampfphase ermöglicht die Abscheidung besonders gut haftender, gleichmäßiger, dünner Schichten.

Der Druck in der Dampfphase bzw. Gasphase kann mehr oder weniger hoch sein. Man kann beispielsweise bei einem Druck arbeiten, der dem Dampfdruck der verwendeten Ausgangsverbindung bei der Arbeitstemperatur entspricht. Der Gesamtdruck kann aber auch höher sein, bis hin zum Normaldruck. Zweckmäßig arbeitet man bei vermindertem Druck, beispielsweise bei $10^{-2}$ bis 10 mbar, vorzugsweise bei 0,1 bis 1 mbar.

Die Zersetzung der Ausgangsverbindung in der Dampfphase oder Gasphase führt man zweckmäßig nach Art eines CVD(Chemical-Vapour-Deposition)-Verfahrens durch. Diese bevorzugte Ausführungsform des erfindungsgemäßen Verfahrens wird im folgenden näher erläutert.

Die prinzipielle Vorgehensweise zur Beschichtung von Substraten unter Anwendung von CVD-Verfahren sowie geeigneter Apparaturen dafür sind bekannt. Die EP-A 297 348 (die sich allerdings mit völlig anderen Beschichtungen befaßt als die vorliegende Erfindung, nämlich mit der Abscheidung von Kupfer, Silber oder Gold enthaltenden Schichten) gibt dem Fachmann ausführliche Hinweise, wie ein CVD-Verfahren durchzuführen ist und welche Apparaturen verwendbar sind.

Die Zersetzung aus der Dampfphase bzw. Gasphase wird zweckmäßig in einer druckfesten, evakuierbaren Vorrichtung durchgeführt. In diese Vorrichtung wird das zu beschichtende Substrat eingebracht. Bei vermindertem Druck wird eine Atmosphäre erzeugt, welche die Ausgangsverbindung enthält. Neben der dampf-bzw. gasförmigen Ausgangsverbindung kann gewünschtenfalls Inertgas oder Reaktivgas im Gasraum der Vorrichtung vorhanden sein.

In einer Variante wird die Ausgangsverbindung

zusammen mit dem zu beschichtenden Substrat in die Vorrichtung eingebracht.

In einer alternativen, bevorzugten Variante wird zunächst nur das Substrat in die druckfeste Vorrichtung eingebracht und die bereits gas- bzw. dampfförmig vorliegende Ausgangsverbindung über eine besondere Leitung kontinuierlich oder diskontinuierlich in die Vorrichtung eingebracht. Auch hier kann ein Trägergas angewendet werden.

Die Überführung der Ausgangsverbindung in die Dampf- bzw. Gasphase kann man durch Erwärmen und gewünschtenfalls durch Zusatz eines Trägergases unterstützen.

Die Zersetzung erfolgt nach bekannten Methoden thermisch, plasmainduziert und/oder photolytisch.

Die thermische Zersetzung aus der Dampfphase führt man üblicherweise so durch, daß die Wände der Vorrichtung kalt gehalten werden und das Substrat auf eine Temperatur erhitzt wird, bei welcher sich die gewünschte Übergangsmetall enthaltende Schicht auf dem Substrat abscheidet. Der Fachmann kann durch einfache orientierende Versuche für die jeweils eingesetzte Verbindung die notwendige Mindesttemperatur leicht bestimmen. Für Wolframverbindungen liegt sie z.B. oberhalb von etwa 80 °C.

Die Beheizung der Substrate kann in üblicher Weise erfolgen, beispielsweise durch Widerstandsheizung, Induktionsheizung, elektrische Heizeinrichtung wie Heizwendeln oder ähnlichem. Die Aufheizung der Substrate kann auch durch Strahlungsenergie induziert werden. Hierfür eignet sich insbesondere Laserstrahlungsenergie. Beispielsweise kann man Laser verwenden, die im Bereich des sichtbaren Lichtes, im UV-Bereich oder im IR-Bereich arbeiten. Laser besitzen den Vorteil, daß man sie mehr oder weniger fokussieren kann und daher gezielt bestimmte, begrenzte Bereiche oder Punkte des Substrats erhitzen kann.

Da das thermische CVD-Verfahren üblicherweise bei Unterdruck, beispielsweise bei einem Druck von $10^{-2}$ bis 10 mbar, vorzugsweise 0,1 bis 1 mbar, durchgeführt wird, ist es für den Fachmann selbstverständlich, druckfeste Apparaturen vorzusehen, wie sie in der Vakuumtechnik verwendet werden. Die Apparaturen weisen zweckmäßigerweise beheizbare Gasleitungen für die verwendete Koordinationsverbindung oder das Inertgas, absperrbare Öffnungen für Gaseinlaß und Gasauslaß auf, gegebenenfalls Öffnungen zur Zuführung eines Trägers oder Reaktivgases, Temperaturmeßeinrichtungen, gewünschtenfalls eine Öffnung für die Zuführung der verwendeten Koordinationsverbindung, eine Einrichtung für die Aufheizung des Substrats, eine zur Erzeugung des gewünschten Unterdruckes geeignete Pumpe etc. Für den Fall der Durchführung eines durch Strahlungsenergie induzierten CVD-Verfahrens muß auch noch eine Strahlungsquelle vorhanden sein, die Strahlung im Bereich des sichtbaren Lichtes, des Infrarot- oder Ultraviolett-Bereiches abgibt. Besonders geeignet sind entsprechende Laser-Strahlungsenergiequellen. Mittels der Strahlungsenergie kann das Substrat aufgeheizt werden.

Wie schon gesagt, kann die Zersetzung auch photolytisch bewirkt werden, indem man einen mit geeigneter Wellenlänge arbeitenden Laser oder eine UV-Lampe verwendet.

Die plasmainduzierte Zersetzung führt man in einer schon vorstehend beschriebenen Apparatur durch.

Ohne daß hier eine Erklärung für die Bildung einer Schicht durch Zersetzung der Ausgangsverbindungen gegeben werden soll, wird angenommen, daß Gase bzw. Dämpfe der Verbindung auf das erhitzte Substrat gelangen und dort unter Bildung der Schicht zersetzt werden. Die Dicke der Schicht ist im wesentlichen abhängig von der Zeitdauer, während welcher die Abscheidung durchgeführt wird, vom Partialdruck und von der Abscheidungstemperatur. Es lassen sich mehr oder weniger dünne Schichten erzeugen, beispielsweise Schichten mit einer Dicke von bis zu 20 Mikrometer, beispielsweise zwischen 100 Angström und 20 Mikrometer. Je nach gewünschter Schichtdicke kann der Fachmann durch orientierende Versuche die zur Erzeugung einer Wolfram enthaltenden Schicht bestimmter Dicke notwendige Zeitdauer und Abscheidungstemperatur bestimmen.

Der das Substrat umgebende Raum enthält die gas- bzw. dampfförmig vorliegende Ausgangsverbindung. Es wurde bereits weiter oben erwähnt, daß weiterhin ein Inertgas oder ein Reaktivgas in der Gas- bzw. Dampfatmosphäre enthalten sein kann. Abhängig von der Art der Durchführung werden ganz unterschiedliche Wolfram enthaltende Schichten abgeschieden.

Zersetzt man die Ausgangsverbindung ohne Zusatz eines Inertgases oder eines Reaktivgases oder nur in Gegenwart eines Inertgases, so scheiden sich bei thermischer Zersetzung, insbesondere bei der Durchführung als CVD-Verfahren, Schichten ab, die Wolfram im wesentlichen in metallischer Form enthalten. Dies geschieht auch in Wasserstoff als Reaktivgas enthaltender Atmosphäre.

In einer anderen Ausführungsform führt man die Zersetzung in einer Reaktivgasatmosphäre durch. Eine solche reaktive Gasatmosphäre kann natürlich zusätzlich Inertgas enthalten, beispielsweise Edelgase wie Argon.

In einer Variante führt man die Zersetzung insbesonder nach Art eines thermischen oder plasmainduzierten CVD-Verfahren durch. Durch Zersetzung der Ausgangsverbindung in einer Reaktivgasatmosphäre, die die Carbidbildung fördert, beispielsweise einer Atmosphäre, die kohlenstoffhaltige Gaszusätze, z.B. Kohlenwasserstoffe, insbesondere kurzkettige Alkane wie Methan, Ethan oder Propan enthält, oder einer Gasatmosphäre, die die Carbonitridbildung fördert, z.B. einer Atmosphäre, die kohlenstoffhaltige Gaszusätze, z.B. Kohlenwasserstoffe, insbesondere kurzkettige Alkane wie Methan, Ethan oder Propan und ggf. $NH_3$, $N_2$ oder N-haltige Gaszusätze enthält, bilden sich Schichten, die das Übergangsmetall im wesentlichen in Form des Carbids oder Carbonitrids, $MtC_xN_y$, enthalten. In den Carbonitriden beträgt die Summe von x und y etwa 1 bis 1,1. Es lassen sich also auch nichtstöchiometrische Zusammensetzungen herstellen.

In einer anderen Variante führt man die Zersetzung ebenfalls insbesondere nach Art eines thermischen oder plasmainduzierten CVD-Verfahrens durch und zersetzt die Wolfram enthaltende Ausgangsverbindung in einer hydrolysierenden und/oder oxidierenden Reaktivgasatmosphäre. Zweckmäßig enthält diese Reaktivgasatmosphäre Wasser und/oder $N_2O$, Sauerstoff oder Ozon. Bei der Zersetzung bilden sich Schichten, die das Übergangsmetall im wesentlichen in Form des Oxids enthalten.

Im erfindungsgemäßen Verfahren kann man im Prinzip beliebige Substrate beschichten, auf denen eine Beschichtung wünschenswert ist. Beispielsweise kann man anorganische Materialien, wie Metalle oder Metallegierungen, z.B. Stahl, Silicium, Halbleiter, Isolatoren z.B. $SiO_2$, Keramik, oder organische Polymere, z.B. Polyphenylensulfid oder Polyimide, als Substrate verwenden.

Die Abscheidung von Schichten, die das Übergangsmetall, z.B. Wolfram im wesentlichen in Form von metallischem Übergangsmetall enthalten, ermöglicht beispielsweise unter Abdeckung bestimmter nicht zu beschichtender Bereiche nach an sich bekannten Strukturierungsverfahren die Erzeugung für den elektrischen Strom leitfähiger Leiterbahnen auf nichtleitenden Substraten, beispielsweise auf Keramik oder organischen Polymeren. Die Abscheidung von metallischem Platin oder Palladium wird bei der Herstellung elektrischer Kontakte angewandt.

Auf metallischen Substraten beispielsweise beobachtet man unter bestimmten Voraussetzungen an sich bekannte Diffusionsphänomene. Metallisches Wolfram oder Molybdän beispielsweise, aufgebracht auf Siliciumsubstraten, diffundieren bei Aufheizung der Substrate auf hohe Temperatur, beispielsweise 700 °C, in diese Siliciumsubstrate ein und bilden Schichten, die mehr oder weniger Wolfram bzw. Molybdän enthalten und im Grenzfall Wolfram- oder Molybdänisilicid darstellen. Solche Silicide sind Oxidationsschutzschichten in der Elektronik.

Wolframoxid enthaltende Schichten können beispielsweise als dekorative Schichten Anwendung finden, ebenso z.B. Platin oder Palladium enthaltende Schichten.

Carbid oder Carbonitrid enthaltende Schichten, z.B. von Wolfram oder Molybdän, sind z.B. Hartstoffschichten.

Das erfindungsgemäße Verfahren bietet dem Fachmann aber noch weitere Möglichkeiten. Es eignet sich beispielsweise auch zur Abscheidung von Schichten, welche neben dem Übergangsmetall Mt ein oder mehrere andere Metalle enthalten. Diese Ausführungsform des erfindungsgemäßen Verfahrens ist dadurch gekennzeichnet, daß man zur Abscheidung von Übergangsmetall enthaltenden Schichten, welche weiterhin ein oder mehrere andere Metalle enthalten, eine oder mehrere Verbindungen anderer Metalle und eine Verbindung der allgemeinen Formel (I) gleichzeitig zersetzt. Es bilden sich dann Schichten, die das Übergangsmetall Mt und ein oder mehrere andere Metalle in homogener Mischung enthalten. Auch bei dieser Ausführungsform kann man in inerter oder Reaktivgasatmosphäre arbeiten. Man kann natürlich auch zwei Verbindungen der allgemeinen Formel (I) einsetzen, in welchen Mt unterschiedliche Bedeutung besitzt. Durch gleichzeitige Zersetzung beispielsweise von $W(PF_3)_5(PCl_3)$ und $Mo(PF_3)_5(PCl_3)$ in Reaktivgasatmosphäre mit Zusatz von Alkanen, insbesondere kurzkettigen Alkanen, und N-haltigen Zusätzen lassen sich Wolfram-Molybdän-Carbonitrid enthaltende Hartstoffschichten erzeugen.

Weiterhin kann der Fachmann mehrere unterschiedliche Schichten sukzessive nacheinander auf Substraten aufbringen, wobei mindestens eine Schicht gemäß dem erfindungsgemäßen Verfahren erzeugt wird.

Beispielsweise kann man auf einem Substrat nach bekannten Verfahren zunächst eine Titannitrid oder Zirkoniumnitrid enthaltende Schicht abscheiden, welche als Diffusionssperre wirkt und zudem die Haftung weiterer abzuscheidender Schichten verbessert. Dann kann man nach dem erfindungsgemäßen Verfahren durch geeignete Abdeckung bestimmter nicht zu beschichtender Bereiche nach an sich bekannten strukturierungsverfahren Leiterbahnen erzeugen, indem man metallisches Wolfram enthaltende Schichten gemäß dem erfindungsgemäßen Verfahren abscheidet. Gewünschtenfalls kann man dann erneut eine Titannitrid enthaltende Schicht als Schutzschicht abscheiden.

Ein weiterer Gegenstand der vorliegenden Erfindung sind neue, im erfindungsgemäßen Verfahren einsetzbare Verbindungen der allgemeinen Formel (I)

$$MtL_{n-1}(PCl_3) \qquad (I)$$

in denen L CO oder $PF_3$ bedeutet,

Mt ein Übergangsmetall, ausgewählt aus der Nickel, Palladium, Platin, Vanadium, Ruthenium, Osmium, Eisen, Chrom, Molybdän und Wolfram umfassenden Gruppe bedeutet und
n die Koordinationszahl des betreffenden Metallatoms ist und für Nickel, Palladium oder Platin n gleich 4 bedeutet, für Ruthenium, Osmium oder Eisen n gleich 5 bedeutet, und für Vanadium, Chrom, Molybdän oder Wolfram n gleich 6 bedeutet mit Ausnahme von $Ni(CO)_3(PCl_3)$, $W(CO)_5(PCl_3)$, $Cr(CO)_5(PCl_3)$ und $Mo(CO)_5(PCl_3)$.

Bevorzugt bedeutet in den neuen Verbindungen der allgemeinen Formel (I) Mt Chrom, Molybdän, Wolfram, Nickel oder Palladium. Besonders bevorzugt bedeutet Mt Wolfram.

L hat vorzugsweise die Bedeutung Trifluorphosphan. Ganz besonders bevorzugt ist die Verbindung $W(PF_3)_5(PCl_3)$.

Im folgenden wird die Herstellung der Verbindungen der allgemeinen Formel (I) beschrieben.

Zur Herstellung von Verbindungen der allgemeinen Formel (Ia) geht man zweckmäßig von Verbindungen der Formel $Mt(PF_3)_n$ aus. Diese Verbindungen und ihre Herstellung sind bekannt.

Die Herstellung von Tetrakis(trifluorphosphan)-nickel bzw. Tetrakis(trifluorphosphan)palladium aus den mit Jod aktivierten Metallen und Trifluorphosphan bei 400 Atmosphären und 150 °C bzw. 250 Atmosphären und 100 °C beschreiben T. Kruck, K. Baur, W. Lang, Chem. Ber. 101 (1968), Seiten 138 bis 142.

Die Herstellung von Tetrakis(trifluorphosphan)-palladium bzw. Tetrakis(trifluorphosphan)platin aus den entsprechenden Dichloriden, Kupfer-Pulver und Trifluorphosphan bei 100 °C, einer Reaktionszeit von 20 Stunden und 300 Atmosphären bzw. 100 bis 150 Atmosphären beschreiben T. Kruck, K. Baur, Z. Anorg. Allg. Chem. 364 (1969), Seiten 192 bis 208. Die Herstellung von Pentakis-(trifluorphosphan)-Komplexen des Eisens, des Rutheniums und des Osmiums aus den entsprechenden Jodiden, Kupfer-Pulver und Trifluorphosphan bei 400 Atmosphären und 150 bis 250 °C beschreiben T. Kruck, A. Prasch, Z. Anorg. Allg. Chem. 356 (1968), Seiten 118 bis 131. Die Herstellung von Hexakis (trifluorphosphan)chrom aus Tris-($\pi$-Allyl)chrom und Trifluorphosphan bei 20 bis 30 Atmosphären in Äther beschreiben T. Kruck, H.L. Diedershagen, A. Engelmann, Z. Anorg. Allg. Chem. 397 (1973), Seiten 31 bis 39. Tris($\pi$-Allyl)-chrom wiederum wird aus Allylmagnesiumbromid und Chromtrichlorid bei -30 °C bis 0 °C in Ether hergestellt.

In der zuletzt genannten Literaturstelle wird auch die Herstellung von Hexakis(trifluorphosphan)-molybdän und Hexakis(trifluorphosphan)wolfram aus Molybdänpentachlorid bzw. Wolframhexachlorid und Trifluorphosphan bei 200 Atmosphären und 250 °C beschrieben.

Die Überführung der Ausgangsverbindungen der Formel $Mt(PF_3)_n$ in die Verbindungen der allgemeinen Formel (Ia) wird zweckmäßig durch photolytisch induzierte Ligandensubstitution in einem komplexierenden Lösungsmittel durchgeführt. Die Photolyse kann beispielsweise durch Anwendung einer UV-Lampe und eines UV-durchlässigen Quarzglasreaktors bewirkt werden. Als komplexierendes Lösungsmittel verwendet man beispielsweise Ether wie Diethylether oder Tetrahydrofuran oder Nitrile, beispielsweise Acetonitril. Als Zwischenprodukte entstehen Verbindungen, in welchen ein $PF_3$-Molekül durch das komplexierende Lösungsmittel substituiert ist. Nach Unterbrechung der Bestrahlung versetzt man die Lösung dann mit $PCl_3$, worauf der Lösungsmittelligand aus der intermediär entstehenden Verbindung verdrängt wird und sich die Verbindung der allgemeinen Formel (Ia) bildet. Nach Abdampfen leicht flüchtiger Bestandteile kann die Verbindung (Ia) als Rohprodukt oder nach Reinigung durch Umkristallisation eingesetzt werden.

Die vorstehend beschriebene zweistufige Verfahrensweise über eine intermediäre Komplexverbindung ist bevorzugt. Man kann aber bereits die Photolyse in Anwesenheit von $PCl_3$ durchführen. Es bildet sich dann unmittelbar die Verbindung der allgemeinen Formel (Ia).

Einige Verbindungen der allgemeinen Formel $Mt(CO)_{n-1}(PCl_3)$(Ib) und ihre Herstellung sind bereits bekannt. Hier geht man zweckmäßigerweise von $Mt(CO)_n$ aus.

Die Autoren L.S. Meriwether und M.L. Fiene in J.A.C.S. 81 (1959), Seiten 4200 bis 4208 beschreiben die Herstellung von $Ni(CO)_3(PCl_3)$ durch Umsetzung von $Ni(CO)_4$ mit $PCl_3$ in wasserfreiem Äther unter Rückfluß mit anschließendem Abziehen des Lösungsmittels.

Die Herstellung von $Cr(CO)_5(PCl_3)$ durch Umsetzung von $Cr(CO)_6$ in Tetrahydrofuran bis zur Abspaltung eines Mols CO unter Bestrahlung und anschließender Zugabe des Liganden $PCl_3$, abtrennen des Lösungsmittels und Sublimation der Verbindung aus dem Rückstand im Hochvakuum beschreiben W. Strohmeier und F.-J. Müller in Chem. Ber. 102 (1969), Seiten 3608 bis 3612.

Die Herstellung der entsprechenden Wolfram- und Molybdän-Verbindungen beschreiben R. Poilblanc, M. Bigorgne in Compt. Rend. 252 (1961), Seiten 3054 bis 3056 sowie in Bull. Soc. Chim. France 1962, Seiten 1301 bis 1325.

Die anderen Verbindungen der allgemeinen Formel (Ib) können in analoger Weise hergestellt werden.

Verbindungen der allgemeinen Formel $Mt(CO)_m(PF_3)_{n-1-m}(PCl_3)$(Ic) können analog hergestellt werden. Zum Beispiel kann man in der an sich be-

kannten Verbindung $W(PF_3)_3(CO)_3$ einen CO-Liganden gegen $PCl_3$ austauschen, indem man nach der vorstehend beschriebenen Technik arbeitet.

Die im erfindungsgemäßen Verfahren anwendbaren Verbindungen sind vorteilhafterweise sehr leicht zugänglich und gut handhabbar. Ihre Zersetzungstemperatur ist recht niedrig. Dies alles führt zu einem besonders vorteilhaften Verfahren.

Die folgenden Beispiele sollen die Erfindung weiter erläutern, ohne sie in ihrem Umfang einzuschränken.

Beispiel 1:

Herstellung von (Trichlorphosphan)pentakis-(trifluorphosphan)wolfram(O), $W(PF_3)_5(PCl_3)$

1.1. Verwendete Apparatur

Verwendet wurde eine Außenbestrahlungsapparatur aus Quarzglas mit einer Quecksilber-Hochdrucklampe (Firma Quarzlampen GmbH, Hanau, Modell Q 600).

1.2. Durchführung

Alle Arbeiten wurden unter Argonatmosphäre durchgeführt. Das verwendete Trichlorphosphan wurde frisch destilliert eingesetzt.

In 100 ml trockenem sauerstofffreiem Diethylether wurden 0,86 g (1,20 mmol) $W(PF_3)_6$ gelöst und bei -15 °C in der Außenbestrahlungsapparatur mit der Quecksilber-Hochdrucklampe mit UV-Licht bestrahlt, bis eine klare, hellgelbe Lösung vorlag. Dies war nach etwa 2 Stunden der Fall. Danach wurde die Bestrahlung beendet und ca. 6 ml Trichlorphosphan in die Lösung eingegeben. Die Lösung wurde dann noch ca. 15 Stunden bei Umgebungstemperatur gerührt.

Danach wurde das Lösungsmittel und überschüssiges Trichlorphosphan im Vakuum bei Umgebungstemperatur abkondensiert und das Produkt aus dem festen Rückstand bei 40 bis 50 °C und $10^{-1}$ mbar heraussublimiert.

Ausbeute: 0,63 g (0,82 mmol) $W(PF_3)_5$ $PCl_3$, d.h. etwa 69 % der Theorie bezogen auf die eingesetzte Wolfram-Verbindung.

Das Produkt war ein farbloser, kristalliner Feststoff, der sich beim Aufheizen zwischen 170 und 190 °C zersetzte.

Beispiel 2:

Anwendung von (Trichlorphosphan)pentakis-(trifluorphosphan)Wolfram(0) zur Schichtabscheidung

2.1. Verwendete Apparatur:

Verwendet wurde ein konventioneller Kaltwand-CVD-Reaktor mit Feststoffsublimator, Trägergaszuleitung, Heizeinrichtungen und Einrichtungen zur Temperaturmessung und Druckmessung. Der Reaktor war über eine tiefkühlbare Kondensationseinrichtung (Tiefkühlfalle) mit einer Vakuumpumpe verbunden.

2.2. Durchführung

Die Wolframverbindung wurde unter Inertgasatmosphäre (Argon) in den Sublimator eingefüllt und auf etwa 100 °C erwärmt. Als Substrat wurden Siliciumscheiben verwendet, die auf eine Temperatur von etwa 250 °C aufgeheizt wurden. Als Trägergas diente Wasserstoff. Der Druck wurde auf etwa 1 bis 3 Torr eingeregelt, und die Abscheidedauer betrug etwa 15 Minuten.

Danach wurde die Apparatur mit Argon auf Normaldruck gebracht. Auf den Siliciumscheiben hatte sich metallisches Wolfram schichtförmig abgeschieden.

## Patentansprüche

**1.** Verfahren zur Abscheidung von Übergangsmetall enthaltenden Schichten durch Zersetzung von Halogenphosphane enthaltenden Koordinationsverbindungen von Übergangsmetallen mit der Wertigkeit 0, dadurch gekennzeichnet, daß man eine Verbindung der allgemeinen Formel (I) einsetzt

$MtL_{n-1}(PCl_3)$ (I)

worin

L CO (Kohlenmonoxid) oder $PF_3$ - (Phosphortrifluorid) bedeutet,

Mt ein Übergangsmetall, ausgewählt aus der Nickel, Palladium, Platin, Vanadium, Ruthenium, Osmium, Eisen, Chrom, Molybdän und Wolfram umfassenden Gruppe bedeutet und

n die Koordinationszahl des betreffenden Metallatoms ist und für Nickel, Palladium oder Platin n gleich 4 bedeutet, für Ruthenium, Osmium oder Eisen n gleich 5 bedeutet, und für Vanadium, Chrom, Molybdän oder Wolfram n gleich 6 bedeutet.

**2.** Verfahren nach Anspruch 1, dadurch gekennzeichnet, daß Mt Chrom, Molybdän, Wolfram, Nickel oder Palladium bedeutet.

**3.** Verfahren nach Anspruch 1 oder 2, dadurch

gekennzeichnet, daß Mt Wolfram bedeutet.

**4.** Verfahren nach einem der vorhergehenden Ansprüche, dadurch gekennzeichnet, daß L Phosphortrifluorid bedeutet.

**5.** Verfahren nach einem der Ansprüche 1 bis 4, dadurch gekennzeichnet, daß man die Verbindung der allgemeinen Formel (I) in der Flüssigphase zersetzt.

**6.** Verfahren nach Anspruch 5, dadurch gekennzeichnet, daß man die Verbindung der allgemeinen Formel (I) auf das Substrat aufbringt, vorzugsweise aufsprüht, und zersetzt.

**7.** Verfahren nach einem der Ansprüche 1 bis 4, dadurch gekennzeichnet, daß man die Verbindung der allgemeinen Formel (I) in der Dampfphase zersetzt.

**8.** Verfahren nach Anspruch 7, dadurch gekennzeichnet, daß man die Verbindung der allgemeinen Formel (I) unter vermindertem Druck, gewünschtenfalls unter Anwendung eines Trägergases, in die Dampfphase überführt und bei vermindertem Druck zersetzt.

**9.** Verfahren nach einem der vorhergehenden Ansprüche, dadurch gekennzeichnet, daß man die Zersetzung thermisch bewirkt.

**10.** Verfahren nach einem der vorhergehenden Ansprüche, dadurch gekennzeichnet, daß man die Zersetzung mittels Strahlungsenergie, insbesondere Laserstrahlungsenergie bewirkt.

**11.** Verfahren nach einem der Ansprüche 1 bis 8, dadurch gekennzeichnet, daß man die Zersetzung plasmainduziert bewirkt.

**12.** Verfahren nach einem der vorhergehenden Ansprüche, dadurch gekennzeichnet, daß man zur Abscheidung von ein Übergangsmetall enthaltenden Schichten, welche das Übergangsmetall im wesentlichen in metallischer Form enthalten, die Zersetzung in einer gegenüber dem gebildeten Metall und der verwendeten Verbindung der allgemeinen Formel (I) inerten, ggf. Wasserstoff enthaltenden Gasatmosphäre durchführt.

**13.** Verfahren nach einem der Ansprüche 1 bis 11, dadurch gekennzeichnet, daß man zur Abscheidung von Übergangsmetall enthaltenden Schichten, welche das Übergangsmetall im wesentlichen in Form der Carbide, Carbonnitride oder Oxide enthalten, die Zersetzung in Anwesenheit einer reaktiven Atmosphäre, vorzugsweise einer oxidierenden, hydrolysierenden oder carbonisierenden bzw. die Carbidbildung oder Carbonitridbildung fördernden Gasatmosphäre durchführt.

**14.** Verfahren nach einem der vorhergehenden Ansprüche, dadurch gekennzeichnet, daß man zur Abscheidung von ein Übergangsmetall enthaltenden Schichten, welche weiterhin ein anderes Metall oder mehrere andere Metalle enthalten, eine oder mehrere Verbindungen solcher anderen Metalle sowie eine Verbindung der allgemeinen Formel (I) gleichzeitig zersetzt.

**15.** Verfahren nach einem der vorhergehenden Ansprüche, dadurch gekennzeichnet, daß man mehrere unterschiedliche Schichten nacheinander abscheidet.

**16.** Verbindungen der allgemeinen Formel (I)

$MtL_{n-1}(PCl_3)$ (I)

worin
L CO oder PF3 bedeutet,

Mt ein Übergangsmetall, ausgewählt aus der Nickel, Palladium, Platin, Vanadium, Ruthenium, Osmium, Eisen, Chrom, Molybdän und Wolfram umfassenden Gruppe bedeutet und

n die Koordinationszahl des betreffenden Metallatoms ist und für Nickel, Palladium oder Platin n gleich 4 bedeutet, für Ruthenium, Osmium oder Eisen n gleich 5 bedeutet, und für Vanadium, Chrom, Molybdän oder Wolfram n gleich 6 bedeutet mit Ausnahmen von $Ni(CO)_3(PCl_3)$, $W(CO)_5(PCl_3)$, $Cr(CO)_5(PCl_3)$ und $Mo(CO)_5(PCl_3)$.

**17.** Verbindungen nach Anspruch 16, dadurch gekennzeichnet, daß Mt Chrom, Molybdän, Wolfram, Nickel oder Palladium, bevorzugt Wolfram bedeutet.

**18.** Verbindungen nach Anspruch 16 oder 17, dadurch gekennzeichnet, daß L Phosphortrifluorid bedeutet.

**19.** $W(PF_3)_5(PCl_3)$ .

Europäisches Patentamt

# EUROPÄISCHER RECHERCHENBERICHT

Nummer der Anmeldung

**EP 91 11 2175**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 355 296 (SIEMENS AG)<br>* the whole document * * | 1-12,16 | C 23 C 16/06<br>C 07 F 19/00<br>C 01 G 1/00 |
| A,D | EP-A-0 338 206 (SIEMENS AG)<br>* the whole document * * | 1-12,16 | |
| A | DE-A-1 900 119 (SIEMENS AG)<br>* the whole document * * | 1-10,16 | |
| A | APPLIED PHYSICS A vol. 38, no. 3, November 1985, BERLIN, DE pages 227 - 233; H. SCHROEDER ET AL: 'INVESTIGATION OF UV-LASER INDUCED METALLIZATION PLATINUM FROM PT(PF3)4'<br>* the whole document * * | 1,4-8,10,12 | |
| A | CHEMICAL ABSTRACTS, vol. 108, no. 2, 11 January 1988, Columbus, Ohio, US; abstract no. 15362S, WEN HUAN HWANG ET AL: 'GAS CHROMATOGRAPHIC SEPARATION OF PHOSPHORUS TRIFLUORIDE SUBSTITUTED GROUP 6 METAL CARBONYL COMPLEXEX...' page 628 ;column 1 ;<br>* abstract * * | 1,16 | |
| A | DE-A-3 830 963 (INCO LTD) | | **RECHERCHIERTE SACHGEBIETE (Int. Cl.5)**<br>C 23 C |
| A | SOLAR ENERGY MATERIALS vol. 12, no. 2, May 1985, AMSTERDAM, NL pages 96 - 100; D.D. ALLRED ET AL: 'SELECTIVE SURFACES BY CVD' | | |

Der vorliegende Recherchenbericht wurde für alle Patentansprüche erstellt

| Recherchenort | Abschlußdatum der Recherche | Prüfer |
|---|---|---|
| Den Haag | 22 Oktober 91 | JOFFREAU P.O. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument